# EUROPÄISCHE PATENTANMELDUNG

(11) **EP 2 590 236 A1**
(43) Veröffentlichungstag der Anmeldung: **08.05.2013**
(21) Anmeldenummer: 11188115.7
(22) Anmeldetag: 07.11.2011
(51) Int. Cl.: H01L 33/48, H01L 25/075, H01L 33/62

(54) **Leuchtdiode und Leuchtmittel mit wenigstens zwei Leuchtdioden als Lichtquellen**

(71) Anmelder: Odelo GmbH, 71409 Schwaikheim (DE)
(72) Erfinder: Catic, Samir, 51065 Köln (DE); Olkay, Cem, 58454 Witten (DE); Manth, Thomas, 52076 Aachen (DE)
(74) Vertreter: Benninger, Johannes

(57) **Zusammenfassung**

Es werden eine Leuchtdiode (01) und ein Leuchtmittel mit einer solchen Leuchtdiode (01) als Lichtquelle beschrieben. Die Leuchtdiode (01) umfasst mindestens einen LED-Chip (02) und eine Montageseite (03, 04) mit elektrischen Anschlüssen (05, 06) zur elektrischen Kontaktierung des LED-Chips (02). Die Leuchtdiode (01) weist mindestens zwei in verschiedenen Richtungen zu einer durch die Lichtabstrahlrichtung (07) der Leuchtdiode (01) definierten Achse (08) orientierten Montageseiten (03, 04) auf. Das Leuchtmittel weist mindestens einen Leuchtmittelträger mit wenigstens zwei auf dem mindestens einen Leuchtmittelträger vorgesehenen Montageflächen auf. Dabei kommen wenigstens zwei mit ihren Lichtabstrahlrichtungen 07 eine Leuchtdichteverteilung in wenigstens zwei Vorzugsrichtungen erfüllenden Leuchtdioden 01 als Lichtquellen zum Einsatz, von denen jede Leuchtdiode 01 mit einer ihrer verschiedenen Montageseiten 03, 04 auf einer der Montageflächen unter mechanischer Befestigung und elektrischer Kontaktierung mit Leiterbahnen des Leuchtmittelträgers angeordnet ist.

## Beschreibung

Die Erfindung betrifft eine Leuchtdiode gemäß dem Oberbegriff des Anspruchs 1 und ein Leuchtmittel mit wenigstens zwei solchen Leuchtdioden als Lichtquellen gemäß dem Oberbegriff des Anspruchs 2.

Als Lichtquellen von Leuchtmitteln kommen unter anderem wegen ihres hohen Wirkungsgrads bei der Umwandlung elektrischen Stroms in Licht und ihres damit einhergehend geringen Stromverbrauchs vermehrt Leuchtdioden zum Einsatz.

Herausragende Eigenschaften von Leuchtdioden im Vergleich zu anderen, herkömmlichen Lichtquellen von Leuchtmitteln, wie etwa Glüh- oder Gasentladungslampen, sind eine wesentlich längere Lebensdauer und eine wesentlich höhere Lichtausbeute bei gleicher Leistungsaufnahme. Dadurch und unter anderem auch wegen ihrer kompakteren Abmessungen können durch Verwendung von Leuchtdioden als Lichtquellen Leuchtmittel und damit Leuchten verwirklicht werden, die an fast jede nur erdenkliche Anwendung angepasst sein können.

In einem Leuchtmittel können dabei eine oder mehrere, einzeln oder gruppenweise, beispielsweise in einem Strang zu mehreren angeordnete Leuchtdioden als mindestens eine Lichtquelle vorgesehen sein.

Ein mit einer oder mehreren, einzeln oder gruppenweise angeordneten Leuchtdioden als mindestens eine Lichtquelle ausgestattetes Leuchtmittel umfasst wenigstens einen Leuchtmittelträger mit Leiterbahnen zur elektrischen Kontaktierung der Leuchtdioden, beispielsweise in Form einer oder mehrerer ebener Platinen mit aufgedruckten oder geätzten Leiterbahnen, so genannter Printed Circuit Boards, kurz PCB, oder in Form eines oder mehrerer als Kunststoffspritzteil in Molded Interconnect Devices (MID) Technik hergestellter, spritzgegossener Schaltungsträger mit in das Kunststoffspritzteil integrierten Leiterbahnen und integrierter mechanischer und elektrischer bzw. elektronischer Funktion. Auf einem oder mehreren solchen spritzgegossenen Schaltungsträgern mit komplexen Formen können eine oder mehrere Leuchtdioden unter gleichzeitiger mechanischer Befestigung und elektrischer Kontaktierung angeordnet sein. Ebene Platinen bzw. PCBs benötigen selbst einer mechanischen Befestigung beispielsweise in einer Leuchte, wohingegen spritzgegossene Schaltungsträger in MID-Technik selbst Funktionen beispielsweise eines Leuchtengehäuses und/oder eines Reflektors übernehmen und ausführen können, um nur einige Beispiele zu nennen.

Darüber hinaus kann das Leuchtmittel ein oder mehrere Elektronikbauelemente umfassen.

Zum Betrieb von Leuchtdioden als Lichtquellen für ein Leuchtmittel können eine oder mehrere mehr oder minder komplexe elektronische Steuerschaltungen vorgesehen sein, die beispielsweise auf einem oder mehreren Leuchtmittelträgern des Leuchtmittels angeordnet, dort mechanisch befestigt und elektrisch kontaktiert sein können.

Ein einfaches Beispiel für eine elektronische Steuerschaltung betrifft die Angleichung unterschiedlicher Helligkeiten einzelner Leuchtdioden oder von Leuchtdioden-Strängen innerhalb einer Gruppe gemeinsam betriebener, auf einem oder mehreren Leuchtmittelträgern angeordneter Leuchtdioden. Eine solche elektronische Steuerschaltung besteht aus mindestens einem oder mehreren Vorwiderständen zur Anpassung der Vorwärtsspannung der Leuchtdioden an die Stromversorgung. Beispielsweise ist bekannt, die Leuchtdioden im so genannten Binning nach Vorwärtsspannung und Intensität zu sortieren. Um Unterschiede zwischen mehreren Leuchtdioden-Strängen auszugleichen, die jeweils aus in Reihe geschalteten Leuchtdioden gleicher Vorwärtsspannung und Intensität bestehen, und um eine homogene Helligkeitsverteilung der benachbarten Leuchtdioden-Stränge aus Leuchtdioden mit unterschiedlicher Vorwärtsspannung und Intensität zu erhalten, wird zumindest jeder Leuchtdioden-Strang mit einem anderen Vorwiderstand versehen.

Leuchtdioden bedürfen darüber hinaus beim Einsatz als Lichtquelle insbesondere in Kraftfahrzeugleuchten oft einer separaten Ausfallerkennung. Dies ist bedingt durch die geringe Leistungsaufnahme von Leuchtdioden im Allgemeinen. Beispielsweise ist ein in einem Kraftfahrzeug untergebrachtes Steuergerät nicht in der Lage, eine dem Ausfall einer oder weniger Leuchtdioden entsprechende Änderung der Leistungsentnahme aus dem die Stromversorgung bildenden Bordnetz zu erkennen, da eine hieraus resultierende Bordnetzspannungsänderung unterhalb der im normalen Betrieb eines Kraftfahrzeugs auftretenden Bordnetzspannungssschwankung liegt. Eine beispielsweise in der Kraftfahrzeugleuchte untergebrachte elektronische Schaltungsanordnung zur Ausfallerkennung erfasst den Ausfall einer oder mehrerer Leuchtdioden in der Kraftfahrzeugleuchte z.B. mittels eines oder mehrerer Komparatoren und teilt dies dem Steuergerät mit. Diese elektronische Schaltungsanordnung zur Ausfallerkennung kann durch eine beispielsweise auf dem Leuchtmittelträger aufgebrachte elektronische Steuerschaltung verwirklicht sein.

Darüber hinaus können Leuchtdioden weiterer elektronischer Steuerschaltungen bedürfen. Beispiele hierfür sind elektronische Steuerschaltungen:
- zur Regelung und/oder Steuerung der Helligkeit bzw. Leuchtkraft der Leuchtdioden, beispielsweise durch eine pulsweitenmodulierte Taktung der Stromversorgung für einen außerhalb des für das menschliche Auge wahrnehmbaren Bereichs gepulsten Betrieb,
- zur Kompensation oder Vermeidung elektromagnetischer Störungen, beispielsweise aufgebaut aus Kondensatoren und/oder Ferriten,
- zum Schutz der Leuchtdioden z.B. vor einer Überspannung der Stromversorgung oder vor fehlerhafter Polung, beispielsweise umfassend eine oder mehrere Zenerdioden,

Zusammengefasst muss für fast alle Leuchtdioden-Anwendungen eine mehr oder minder umfangreiche, für die speziellen Leuchtdioden ausgelegte elektronische Steuerschaltung z.B. auf den mindestens einen Leuchtmittelträger aufgebracht werden. Die elektronische Steuerschaltung umfasst im einfachsten Fall einen Vorwiderstand und eine Schutzdiode, kann aber je nach Anwendung auch wesentlich mehr Elektronikbauteile enthalten, wie z.B. Mikrokontroller bzw. Kontroller, Komparatoren, Transistoren, Schutzdioden, elektrische Widerstände z.B. als Vorwiderstand, Kondensatoren, Ferrite, etc.

Somit kann ein Leuchtmittel mit einer oder mehreren Leuchtdioden als Lichtquelle zumindest ein oben genanntes Elektronikbauteil sowie mindestens eine Leuchtdiode umfassen. Demnach kann ein Leuchtmittel mit einer oder mehreren Leuchtdioden als Lichtquellen neben der mindestens einen Leuchtdiode zumindest noch über ein weiteres Elektronikbauelement verfügen.

Eine zur Verwendung als Lichtquelle eines Leuchtmittels vorgesehene, zur Montage auf einem Leuchtmittelträger ausgebildete Leuchtdiode besteht zumindest aus wenigstens einem Lichtemittierende-Diode-Halbleiter-Chip, kurz LED-Chip, sowie aus mindestens einem Kontaktmittel zur elektrischen Kontaktierung des LED-Chips. Üblicherweise verfügt jede Leuchtdiode über einen Bonddraht je LED-Chip, welcher je einen LED-Chip elektrisch kontaktiert. Dieser Bonddraht bildet wenigstens ein Kontaktmittel der Leuchtdiode. Der Bonddraht kann mit einem elektrischen Anschluss verbunden sein, welcher zur elektrischen Kontaktierung der Leuchtdiode mit einer Leiterbahn des Leuchtmittelträgers vorgesehen ist. Der LED-Chip ist darüber hinaus selbst zur elektrischen Kontaktierung mit einer zweiten Leiterbahn des Leuchtmittelträgers vorgesehen, beispielsweise über einen mit dem LED-Chip verbundenen zweiten elektrischen Anschluss. Auch kann der LED-Chip selbst einen elektrischen Anschluss der Leuchtdiode bilden, wie nachfolgend zu den verschiedenen Kontaktierungsmöglichkeiten von Leuchtdioden noch ausgeführt.

Die Leuchtdiode kann darüber hinaus einen den LED-Chip unmittelbar umgebenden Primärreflektor aufweisen. Dieser Primärreflektor kann beispielsweise durch Wandungen einer den LED-Chip umgebenden Ausnehmung und/oder durch einen Napf gebildet sein, in dem der LED-Chip angeordnet ist. Der Napf kann mit dem erwähnten zweiten Anschluss verbunden sein, diesen bilden oder umfassen oder von diesem umfasst werden. Der zweite Anschluss bildet ebenfalls ein Kontaktmittel der Leuchtdiode. Der zweite Anschluss kann jedoch auch durch den LED-Chip selbst gebildet sein, indem der LED-Chip selbst unmittelbar auf einer ersten Leiterbahn des Leuchtmittelträgers platziert wird. In diesem Fall bilden der auf einer ersten Leiterbahn des Leuchtmittelträgers platzierte LED-Chip und der mit einer zweiten Leiterbahn verbundene Bonddraht die Kontaktmittel und gleichzeitig die elektrischen Anschlüsse der Leuchtdiode.

Bekannt sind Leuchtdioden zur Durchsteckmontage (THT; Through Hole Technology), oberflächenmontierbare (SMD; Surface Mounted Device) Leuchtdioden und Leuchtdioden, bei denen der LED-Chip in Nacktmontagetechnik (COB; Chip On Board) direkt auf den Leuchtmittelträger gebondet wird.

THT-Leuchtdioden sind der gängig bekannte Typ Leuchtdioden. Sie werden auch als bedrahtete Leuchtdioden bezeichnet, da sie aus einer zumindest in einer gewünschten Abstrahlrichtung transparenten Kapselung, z.B. in Form einer Umspritzung oder eines Vergusses bestehen, welche den mit einem ersten elektrischen Anschluss, beispielsweise in Form eines Kathodenanschlusses, verbundenen LED-Chip und einen den LED-Chip mit einem zweiten elektrischen Anschluss, beispielsweise in Form eines Anodenanschlusses verbindenden Bonddraht einschließt. Aus der Kapselung ragen nur die auch als Beinchen bezeichneten Drähte des ersten elektrischen Anschlusses und des zweiten elektrischen Anschlusses als die Anoden- und Kathodenanschlüsse der THT-Leuchtdiode. Der beispielsweise als Kathodenanschluss ausgeführte erste elektrische Anschluss kann hierbei mit einem oben erwähnten Napf versehen sein, in dem der LED-Chip angeordnet ist. Der Bonddraht führt vom beispielsweise als Anodenanschluss ausgeführten zweiten Anschluss von außerhalb des Napfs kommend zum LED-Chip.

SMD-Leuchtdioden bestehen aus einem Leadframe mit wenigstens einer Bestückungsfläche für mindestens einen LED-Chip sowie elektrischen Anschlussflächen. Das Leadframe ist von einem Kunststoffkörper mit zumindest einer die wenigstens eine Bestückungsfläche freihaltenden Ausnehmung teilweise umspritzt. Die elektrischen Anschlussflächen des Leadframes sind hierbei als die elektrischen Anschlüsse der SMD-Leuchtdiode zur späteren Oberflächenmontage ebenfalls freigehalten. Der mindestens eine LED-Chip ist am Grund der zumindest einen zur wenigstens einen Bestückungsfläche reichenden Ausnehmung angeordnet und elektrisch kontaktiert. Dabei ist der LED-Chip auf einer mit wenigstens einer ersten elektrischen Anschlussfläche verbundenen ersten Partie des Leadframes angeordnet. Ein Bonddraht verbindet den LED-Chip mit einer zweiten Partie des Leadframes, die wiederum mit wenigstens einer zweiten elektrischen Anschlussfläche verbunden ist. Die an ihrem Grund zur Bestückungsfläche reichende Ausnehmung kann reflektorartig ausgestaltet sein. Dabei bilden die Wandungen der Ausnehmung den oben erwähnten Primärreflektor. Hierbei können die Wandungen reflektierend beschichtet sein.

COB-Leuchtdioden bestehen aus einem direkt auf einem Leuchtmittelträger anzuordnenden, ungehäusten LED-Chip und einem Bonddraht. Die Rückseite des LED-Chips bildet dabei den ersten elektrischen Anschluss der COB-Leuchtdiode. Zur elektrischen Kontaktierung wird der LED-Chip auf seiner Rückseite direkt mit einer ersten Leiterbahn eines Leuchtmittelträgers z.B. durch Löten oder Schweißen elektrisch verbunden. Der den zweiten elektrischen Anschluss der COB-Leuchtdiode bildende Bonddraht wird mit einer zweiten Leiterbahn des Leuchtmittelträgers ebenfalls z.B. durch Löten oder Schweißen elektrisch verbunden.

Der Vollständigkeit halber sei ergänzend erwähnt, dass auch andere Kontaktierungen wie z.B. der so genannte Flip-Chip-Aufbau möglich sind, bei dem die Kontaktmittel des LED-Chips direkt mit einem kontaktierten Substrat verbunden sind. In diesen Fällen wird kein Bonddraht verwendet.

Zusammengefasst weisen damit alle Leuchtdioden eine Montageseite auf, an der sich die elektrischen Anschlüsse befinden. Bei einer THT- oder SMD-Leuchtdiode ist dies diejenige Seite ihres die elektrischen Anschlüsse wenigstens teilweise umgebenden, beispielsweise durch die transparente Kapselung oder durch den Kunststoffkörper gebildeten, üblicherweise durch Spritzgießen hergestellten Schutzkörpers, aus der die elektrischen Anschlüsse wie bei der THT-Leuchtdiode ragen, oder an der die elektrischen Anschlussflächen des Leadframes freigehalten sind. Bei der COB-Leuchtdiode ist dies die der Lichtabstrahlrichtung abgewandte Rückseite des LED-Chips.

Zur Montage und elektrischen Kontaktierung von Leuchtdioden auf einem Leuchtmittelträger sind Montageflächen an einer oder mehreren Oberflächen des Leuchtmittelträgers ausgebildet. Im Falle von PCBs sind dies die parallel zu der durch das PCB aufgespannten Ebene liegenden Oberflächen des Leuchtmittelträgers. Im Falle eines in MID-Technik hergestellten spritzgegossenen Schaltungsträgers mit integrierter mechanischer und elektrischer bzw. elektronischer Funktion sind dies als Montageflächen ausgebildete Oberflächenpartien des Leuchtmittelträgers.

Die mindestens eine Montagefläche eines Leuchtmittelträgers ist dabei mit jeweils mindestens einer Leiterbahn des Leuchtmittelträgers elektrisch leitend verbundenen und mit den auf der Montageseite der Leuchtdiode angeordneten elektrischen Anschlüssen der Leuchtdiode korrespondierenden elektrischen Kontakten versehen. Die auf einer Montagefläche eines Leuchtmittelträges vorgesehenen elektrischen Kontakte können beispielsweise durch auf der Montagefläche verlaufende Leiterbahnen gebildet sein, oder durch auf einer der Montagefläche gegenüberliegenden Oberfläche des Leuchtmittelträgers verlaufende Leiterbahnen sowie die Montagefläche mit der gegenüberliegenden Oberfläche verbindende Löcher. In letzterem Fall umfassen die auf der Montageseite der Leuchtdiode oder eines Elektronikbauteils angeordneten elektrischen Anschlüsse Beinchen zur Durchsteckmontage.

Damit das Licht eines Leuchtmittels mit Leuchtdioden als Lichtquellen in einer gewünschten Richtung abgestrahlt wird, müssen entweder die Montageflächen der Leuchtmittelträger oder im Falle von PCBs die Leuchtmittelträger selbst oder die jeweilige Montageseite der Leuchtdioden in einer hierfür erforderlichen Richtung orientiert sein.

Allgemein bekannt sind so genannte planare Leuchtdioden, bei denen die Montageseite eine der Lichtabstrahlrichtung abgewandte Rückseite der Leuchtdiode bildet. Die Lichtabstrahlrichtung zeigt dabei in Richtung der Flächennormalen der Montageseite. Derartige Leuchtdioden werden stehend auf einem Leuchtmittelträger angeordnet.

Nachteilig an diesen Leuchtdioden ist, dass, wenn bei einem mit solchen Leuchtdioden als Lichtquellen ausgestatteten Leuchtmittel eine Lichtabstrahlung in verschiedenen Raumrichtungen verwirklicht werden muss, beispielsweise um bei Verwendung in einer Leuchte, wie etwa in einer Kraftfahrzeugleuchte, gesetzlichen Vorgaben für eine Leuchtdichteverteilung in mehreren Vorzugsrichtungen nachzukommen, der Leuchtmittelträger Montageflächen mit unterschiedlichen Lagen im Raum aufweisen muss. Sind PCBs als Leuchtmittelträger vorgesehen bedeutet dies die Notwendigkeit der Verwendung mehrerer in ihrer Lage im Raum unterschiedlich orientierter PCBs, um einer Lichtabstrahlung in den unterschiedlichen Raumrichtungen nachkommen zu können.

Durch EP 1 588 093 B1 und US 7,905,643 B2 sind als so genannte Sidelooker ausgebildete Leuchtdioden bekannt, bei denen die Lichtabstrahlrichtung parallel zur Montageseite und damit parallel zur Montagefläche des Leuchtmittelträgers verläuft.

Nachteilig an diesen Leuchtdioden ist, dass wenn bei einem mit solchen Leuchtdioden als Lichtquellen ausgestatteten Leuchtmittel eine Lichtabstrahlung in verschiedenen, eine gemeinsame Ebene verlassenden verwirklicht werden muss, beispielsweise um bei Verwendung in einer Leuchte, wie etwa in einer Kraftfahrzeugleuchte, gesetzlichen Vorgaben für eine Leuchtdichteverteilung in mehreren Vorzugsrichtungen nachzukommen, der Leuchtmittelträger ebenfalls Montageflächen mit unterschiedlichen Lagen im Raum aufweisen muss. Sind PCBs als Leuchtmittelträger vorgesehen bedeutet dies die Notwendigkeit der Verwendung mehrerer in ihrer Lage im Raum unterschiedlich orientierter PCBs, um einer Lichtabstrahlung in den unterschiedlichen Raumrichtungen nachkommen zu können.

Durch DE 10 2006 051 542 B4 ist bekannt, bedrahtete Leuchtdioden in einem

Halter mit einer schräg zur Lichtabstrahlrichtung angeordneten Montageseite unterzubringen. Die Beinchen der Leuchtdioden ragen an der Montageseite des Halters aus diesem heraus. Der Halter wird mitsamt den Leuchtdioden auf einem ebenen Leuchtmittelträger montiert. Die Montagefläche eines Leuchtmittelträgers muss zur Aufnahme der Beinchen mit korrespondierenden Löchern versehen sein. Der Leuchtmittelträger ist entweder auf seiner der Montageseite zugewandten Montagefläche, oder auf seiner dieser abgewandten Oberfläche mit den durch die Löcher gesteckten Beinchen der Leuchtdiode korrespondierenden elektrischen Kontakten versehen. Die Beinchen können zur Herstellung des elektrischen Kontakts mit den elektrischen Kontakten beispielsweise verlötet und/oder verschweißt sein.

Nachteilig an dieser Lösung ist, dass, wenn bei einem mit solchen Leuchtdioden als Lichtquellen ausgestatteten Leuchtmittel eine Lichtabstrahlung in verschiedenen, einen gemeinsamen Kegel verlassenden Raumrichtungen verwirklicht werden muss, beispielsweise um bei einer Leuchte, wie etwa einer Kraftfahrzeugleuchte gesetzlichen Vorgaben für eine Leuchtdichteverteilung in mehreren Vorzugsrichtungen nachzukommen, der Leuchtmittelträger ebenfalls Montageflächen mit unterschiedlichen Lagen im Raum aufweisen muss. Sind PCBs als Leuchtmittelträger vorgesehen bedeutet dies die Notwendigkeit der Verwendung mehrerer in ihrer Lage im Raum unterschiedlich orientierter PCBs, um einer Lichtabstrahlung in den unterschiedlichen Raumrichtungen nachkommen zu können.

Die Nachteile des Standes der Technik könnten durch Verwendung von als Kunststoffspritzteil in MID Technik hergestellter, spritzgegossener Schaltungsträger mit in das Kunststoffspritzteil integrierten Leiterbahnen und integrierter mechanischer und elektrischer bzw. elektronischer Funktion ausgebildeter Leuchtmittelträger mit mehrdimensional und multidirektional ausgerichteten Montageflächen teilweise beseitigt werden, wären in MID-Technik hergestellte Schaltungsträger nicht sehr kostspielig in der Herstellung und insbesondere bei einer mehrdimensionalen und multidirektionalen Ausrichtung der Montageflächen sehr kompliziert beim Umgang und der Bestückung mit den als Lichtquellen vorgesehenen Leuchtdioden.

Zusammengefasst sind damit in allen Fällen Leuchtmittelträger bestehend aus mehreren PCBs bzw. Platinen notwendig, einhergehend mit einem hohen Montageaufwand.

Eine Kombination eines Leuchtmittelträgers mit den bekannten Leuchtdioden hat darüber hinaus einen hohen Herstellungsaufwand für die verschieden ausgestalteten Leuchtdioden zur Folge und ist mit einer aufwändigen Lagerhaltung für die verschieden ausgestalteten Leuchtdioden verbunden. Darüber hinaus ergibt sich die Gefahr der Fehlmontage einer Sorte von Leuchtdioden auf für eine andere Sorte von Leuchtdioden vorgesehenen Montageflächen.

Ein Ziel bei der Entwicklung von in Großserie hergestellter Leuchtmittel ist die Verringerung der Kosten. Dies kann erreicht werden beispielsweise durch:
- Einsparungen bei der Anzahl der benötigten Einzelteile, wodurch der Montageaufwand und dadurch die benötigte Zeit zur Montage verringert werden können, einhergehend mit verringerten Montagekosten,
- Einsparungen bei der Anzahl der verschiedenartigen Einzelteile, wodurch es zu weniger Fehlmontagen kommt und der Ausschuss verringert werden kann, was die Gesamtkosten senkt, und darüber hinaus eine vereinfachte Lagerlogistik einhergehend mit verringerten Lagerhaltungskosten erreicht werden,
- Einsparungen bei der Anzahl von unter verschiedenen Raumrichtungen orientierter Montageflächen und Leuchtmittelträger unter gleichzeitiger Einhaltung und Erfüllung der an ein Leuchtmittel gestellten Forderungen hinsichtlich der Lichtabstrahlung in vorgegebener Leuchtdichte in einer oder mehreren Vorzugsrichtungen, wodurch Bestückung, Montage und Umgang vereinfacht und dadurch Bestückungs-, Montage- und durch die Verringerung von Ausschuss die Herstellungskosten verringert werden können.

Leuchtmittel mit einer Vielzahl verschiedener benötigter Einzelteile stehen diesem Ziel entgegen.

Eine Aufgabe der Erfindung ist es deshalb, eine Leuchtdiode zu entwickeln, welche die Herstellung von gleichartigen oder verschiedenen Leuchtmitteln mit einer oder mehreren Leuchtdioden als Lichtquellen unter Einhaltung der benannten Einsparungen ermöglicht. Insbesondere ist es eine Aufgabe der Erfindung eine Leuchtdiode zu entwickeln, die zumindest im Vergleich zum Stand der Technik universeller eingesetzt werden kann, um dadurch Montage-, Gesamt- und Lagerhaltungskosten bei der Herstellung von Leuchtmitteln mit Leuchtdioden als Lichtquellen zu verringern.

Eine Aufgabe der Erfindung ist es außerdem ein Leuchtmittel mit mindestens zwei mit ihren Lichtabstrahlrichtungen unterschiedliche Vorzugsrichtungen einer Leuchtdichteverteilung erfüllenden Leuchtdioden als Lichtquellen zu entwickeln.

Die Aufgabe wird gelöst mit den Merkmalen der unabhängigen Ansprüche.

Die Erfindung sieht demnach zur Lösung der Aufgabe unter gleichzeitiger Behebung der genannten Nachteile des Standes der Technik eine Leuchtdiode mit mehreren, unterschiedlichen, vorzugsweise mit jeweils eigenen elektrischen Anschlüssen versehenen Montageseiten vor.

Die Leuchtdiode mit mindestens einem LED-Chip und einer Montageseite mit elektrischen Anschlüssen zur elektrischen Kontaktierung des LED-Chips zeichnet sich durch mindestens zwei in verschiedenen Richtungen zu einer durch die Lichtabstrahlrichtung der Leuchtdiode definierten Achse orientierten Montageseiten aus.

Jede Montageseite kann mit eigenen elektrischen Anschlüssen versehen sein. Auch ist denkbar, gemeinsame elektrische Anschlüsse vorzusehen, die sich beispielsweise über mehrere, beispielsweise alle Montageseiten erstrecken können.

Eine vorteilhafte Ausgestaltung der erfindungsgemäßen Leuchtdiode zeichnet sich durch einen unter Freilassung an den Montageseiten die elektrischen Anschlüsse zumindest teilweise umgebenden, vorzugsweise durch Spritzgießen aus Kunststoff hergestellten Schutzkörper aus.

Die Montageseiten können durch die Form des Schutzkörpers definiert und hergestellt sein. Der Schutzkörper bildet dabei ein Gehäuse der Leuchtdiode, welche aufgrund ihrer Gehäuseform mehrere Montageseiten mit gemeinsamen oder jeweils eigenen elektrischen Anschlüssen aufweist.

Alternativ oder zusätzlich kann zumindest die Orientierung wenigstens einer Montageseite durch die der Lichtabstrahlrichtung der Leuchtdiode abgewandte Rückseite des LED-Chips definiert und/oder hergestellt sein.

Auch eine an die Rückseite des LED-Chips angrenzende Fläche des LED-Chips kann zumindest die Orientierung einer Montagefläche in Bezug auf die Lichtabstrahlrichtung definieren.

Beispielsweise können zwei Montageseiten vorgesehen sein, eine normal zur Lichtabstrahlrichtung orientierte erste Montageseite auf der Rückseite und eine zweite, beispielsweise parallel oder schräg zur Lichtabstrahlrichtung orientierte, beispielsweise an die der Lichtabstrahlrichtung abgewandte Rückseite angrenzende Montageseite.

Bezugnehmend auf eine durch die Lichtabstrahlrichtung der Leuchtdiode gebildete Achse können verschiedene Montageseiten beispielsweise Winkel von 0°, 30°, 45°, 60°, 90° einschließen.

Die Montageseiten können bezüglich einer durch die Lichtabstrahlrichtung der Leuchtdiode definierten Achse auf der selben Seite angeordnet sein, oder es können verschiedene Montageseiten in verschiedenen Winkeln beispielsweise gleichmäßig um diese Achse herum verteilt angeordnet sein.

Die Leuchtdiode kann belinst und/oder mit einer andersartig ausgebildeten Primäroptik versehen sein.

An die Leuchtdiode kann mindestens ein Lichtleiter mit wenigstens einer zur Lichteinkopplung in den Lichtleiter vorgesehenen Lichteinkoppelfläche sowie zumindest einer von der wenigstens einen Lichteinkoppelfläche verschiedenen Lichtauskoppelfläche, durch die das in den Lichtleiter an der Lichteinkoppelfläche eingekoppelte Licht wieder aus dem Lichtleiter austritt, angespritzt sein.

Die Leuchtdiode kann als SMD-LED ausgeführt sein.

Die Leuchtdiode kann als THT-LED ausgeführt sein.

Grundsätzlich kann die Leuchtdiode auch als eine COB-Leuchtdiode ausgeführt sein.

Ein zweiter Gegenstand der Erfindung betrifft ein Leuchtmittel mit wenigstens einem Leuchtmittelträger und wenigstens zwei auf dem mindestens einen Leuchtmittelträger vorgesehenen Montageflächen und wenigstens zwei mit ihren Lichtabstrahlrichtungen eine Leuchtdichteverteilung in wenigstens zwei Vorzugsrichtungen erfüllenden Leuchtdioden als Lichtquellen, von denen jede Leuchtdiode mit einer Montageseite auf einer der Montageflächen unter mechanischer Befestigung und elektrischer Kontaktierung mit Leiterbahnen des Leuchtmittelträgers angeordnet ist.

Das Leuchtmittel zeichnet sich durch mindestens zwei identische zuvor beschriebene Leuchtdioden aus, die, zur Erfüllung unterschiedlicher Vorzugsrichtungen mit ihren Lichtabstrahlrichtungen mit unterschiedlichen Montageseiten auf verschiedenen Montageflächen des Leuchtmittelträgers angeordnet sind.

Als Leuchtmittelträger können Platinen, PCBs und/oder in MID-Technik hergestellte, spritzgegossene Schaltungsträger mit mehreren Montageflächen zum Einsatz kommen.

Es ist ersichtlich, dass die Erfindung durch eine Leuchtdiode mit einem durch einen Schutzkörper gebildeten Gehäuse verwirklicht sein kann, bei welcher Leuchtdiode das Gehäuse konstruktiv so ausgeführt ist dass dieses mehr als eine Montageseite aufweist. Dies ermöglicht eine Ausrichtung der Leuchtdiode auf einer Montagefläche beispielsweise eines Leuchtmittelträgers oder allgemein auf einer Platine oder einem PCB, aber auch auf einer Montagefläche eines in MID-Technik hergestellten spritzgegossenen Schaltungsträgers mit integrierter mechanischer und elektrischer bzw. elektronischer Funktion in mehr als einer Raumrichtung bei gleichzeitiger Verwendung nur eines einzelnen Leuchtdioden-Typs.

Vorteile gegenüber dem Stand der Technik ergeben sich dadurch, dass die Leuchtdiode dank ihrer verschiedenen, in verschiedenen Richtungen zu einer durch die Lichtabstrahlrichtung der Leuchtdiode definierten Achse orientierten Montageseiten mit ihrer Lichtabstrahlrichtung in mindestens zwei verschiedenen Anstellwinkeln zu einer Montagefläche beispielsweise eines Leuchtmittelträgers montierbar ist. Dadurch kann eine erhebliche Vereinfachung, beispielsweise eine Halbierung der einem Leuchtmittel mit einer Leuchtdichteverteilung in mehreren Vorzugsrichtungen, zu deren Einhaltung das Leuchtmittel mit mehreren, jeweils eine Vorzugsrichtung mit ihren Lichtabstrahlrichtungen erfüllenden Leuchtdioden als Lichtquellen zugrundeliegenden Stückliste erzielt werden, da dasselbe Bauteil bzw. die selbe Leuchtdiode durch variable Montage auf ein und der selben Montagefläche in mindestens zwei verschiedenen optische Achsen ausgerichtet werden kann.

Gegenüber dem Stand der Technik ergeben sich dadurch folgende weitere Vorteile:
- Lagerseitig muss eine geringere Variantenanzahl von Leuchtdioden, im Idealfall nur eine, zur Fertigung von mit Leuchtdioden als Lichtquellen ausgestatteten Leuchtmitteln vorgehalten und bestellt werden.
- Logistikseitig ist die Anzahl an zu qualifizierenden und zu betreuenden Lieferanten bei der Fertigung von mit Leuchtdioden als Lichtquellen ausgestatteten Leuchtmitteln geringer.
- Auf der Montagemaschine muss eine geringere Variantenzahl von Leuchtdioden zur Fertigung von mit Leuchtdioden als Lichtquellen ausgestatteten Leuchtmitteln parallel zugeführt werden. Daraus ergibt sich eine geringere Rüstzeit.
- Bei der Konstruktion eines Leuchtmittelträgers für eine mit Leuchtdioden als Lichtquellen ausgestatteten Leuchtmittels ist nur ein Leuchtdiode-Typ zu spezifizieren. Dadurch ergeben sich Einsparungen bei der Entwicklung von Leuchtdioden und mit diesen als Lichtquellen ausgestatteten Leuchtmitteln.

Weitere Vorteile ergeben sich bei der Verwendung der Leuchtdioden in mit Leuchtdioden als Lichtquellen ausgestatteten Leuchtmitteln durch:
- Einsparungen bei der Anzahl der benötigten Einzelteile, wodurch der Montageaufwand und dadurch die benötigte Zeit zur Montage verringert werden können, einhergehend mit verringerten Montagekosten,
- Einsparungen bei der Anzahl der verschiedenartigen Einzelteile, wodurch es zu weniger Fehlmontagen kommt und der Ausschuss verringert werden kann, was die Gesamtkosten senkt, und darüber hinaus eine vereinfachte Lagerlogistik einhergehend mit verringerten Lagerhaltungskosten erreicht werden,
- Einsparungen bei der Anzahl von unter verschiedenen Raumrichtungen orientierter Montageflächen und Leuchtmittelträger unter gleichzeitiger Einhaltung und Erfüllung der an ein Leuchtmittel gestellten Forderungen hinsichtlich der Lichtabstrahlung in vorgegebener Leuchtdichte in einer oder mehreren Vorzugsrichtungen, wodurch Bestückung, Montage und Umgang vereinfacht und dadurch Bestückungs-, Montage- und durch die Verringerung von Ausschuss die Herstellungskosten verringert werden können.

Die Erfindung wird nachfolgend anhand von in den Zeichnungen dargestellter Ausführungsbeispiele näher erläutert. Darin bezeichnen gleiche Bezugszeichen gleiche oder gleich wirkende Elemente. Der Übersicht halber sind nur Bezugszeichen in den einzelnen Zeichnungen dargestellt, die für die Beschreibung der jeweiligen Zeichnung erforderlich sind. Die Größenverhältnisse der einzelnen Elemente zueinander entsprechen dabei nicht immer den realen Größenverhältnissen, da einige Formen vereinfacht und andere Formen zur besseren Veranschaulichung vergrößert im Verhältnis zu anderen Elementen dargestellt sind. Es zeigen in schematischer Darstellung:
- Fig. 1: eine perspektivische Ansicht einer Leuchtdiode mit zwei unter Winkeln von 30° und 90° zu einer durch die Lichtabstrahlrichtung gebildeten Achse angeordneten Montageseiten, gezeigt auf der gegenüber der durch die Lichtabstrahlrichtung gebildeten Achse unter einem Winkel von 30 ° angeordneten Montageseite aufliegend.
- Fig. 2: eine perspektivische Ansicht der Leuchtdiode aus Fig. 1, gezeigt auf der gegenüber der durch die Lichtabstrahlrichtung gebildeten Achse unter einem Winkel von 90° angeordneten Montageseite aufliegend.
- Fig. 3: die Leuchtdiode aus Fig. 1 von ihren ihrer Lichtabstrahlrichtung abgewandten Montageseiten her gesehen.

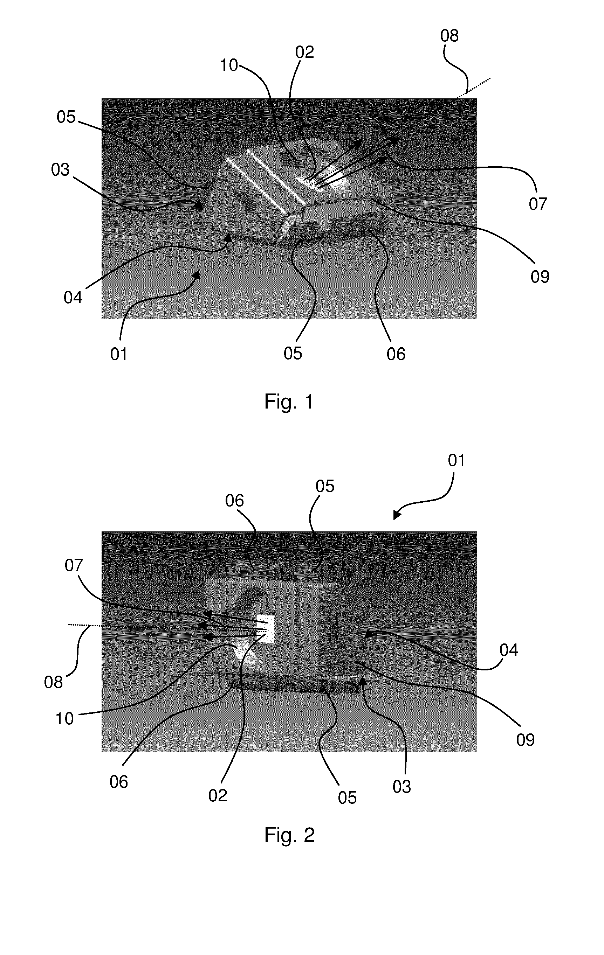

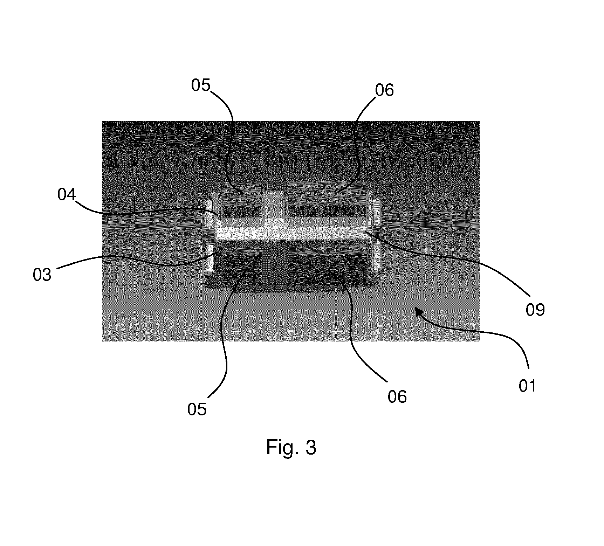

Ein in den Fig. 1 bis Fig. 3 ganz oder in Teilen dargestellte Leuchtdiode 01 umfasst mindestens einen LED-Chip 02 und mindestens zwei verschiedene, in unterschiedlichen Richtungen zu einer durch die Lichtabstrahlrichtung 07 der Leuchtdiode 01 definierten Achse 08 orientierten Montageseiten 03, 04 mit elektrischen Anschlüssen 05, 06 zur elektrischen Kontaktierung des LED-Chips 02.

Bei der Richtung der Orientierung der Montageseiten 03, 04 zu der durch die Lichtabstrahlrichtung 07 der Leuchtdiode 01 definierten Achse 08 kann es sich beispielsweise um den zwischen der durch die Lichtabstrahlrichtung 07 der Leuchtdiode 01 definierte Achse 08 und der jeweiligen Montageseite 03, 04 eingeschlossenen Winkel handeln. Alternativ kann der zwischen der durch die Lichtabstrahlrichtung 07 der Leuchtdiode 01 definierte Achse 08 und der Flächennormalen der jeweiligen Montageseite 03, 04 eingeschlossene Winkel zur Definition der Richtung der Orientierung der Montageseiten 03, 04 herangezogen werden. Die beiden Definitionen der Richtung der Orientierung sind dabei gleichwertig, wobei sich die jeweils eingeschlossenen Winkel bei Betrachtung gemäß der einen Definition mit den jeweiligen eingeschlossenen Winkeln bei Betrachtung gemäß der anderen Definition einander zu einem rechten Winkel von 90° ergänzen.

Im Folgenden handelt es sich bei der Richtung der Orientierung der Montageseiten 03, 04 zu der durch die Lichtabstrahlrichtung 07 der Leuchtdiode 01 definierten Achse 08 um den zwischen der durch die Lichtabstrahlrichtung 07 der Leuchtdiode 01 definierte Achse 08 und der Flächennormalen der jeweiligen Montageseite 03, 04 eingeschlossenen Winkel.

Die Leuchtdiode 01 kann zur Montage auf einem Leuchtmittelträger eines Leuchtmittels mit wenigstens zwei auf dem Leuchtmittelträger vorgesehenen Montageflächen verwendet werden. Dabei kommen wenigstens zwei mit ihren Lichtabstrahlrichtungen 07 eine Leuchtdichteverteilung in wenigstens zwei Vorzugsrichtungen erfüllenden Leuchtdioden 01 als Lichtquellen zum Einsatz, von denen jede Leuchtdiode 01 mit einer ihrer verschiedenen Montageseiten 03, 04 auf einer der Montageflächen unter mechanischer Befestigung und elektrischer Kontaktierung mit Leiterbahnen des Leuchtmittelträgers angeordnet ist.

Vermittels der zwei jeweils mit elektrischen Anschlüssen 05, 06 versehenen verschiedenen Montageseiten 03, 04 kann die Leuchtdiode 01 unter zwei verschiedenen mögliche Montage- bzw. Anstellwinkeln auf einer oder verschiedenen Montageflächen beispielsweise einer Platine oder eines PCBs oder eines in MID-Technik hergestellten spritzgegossenen Schaltungsträgers, die allesamt beispielsweise als Leuchtmittelträger ausgebildet sein können, angeordnet werden.

Die Leuchtdiode 01 kann beispielsweise zwei Montageseiten 03, 04 aufweisen, von denen eine erste Montageseite 03 normal zur durch die Lichtabstrahlrichtung 07 der Leuchtdiode 01 definierten Achse 08 orientiert ist, und von denen eine zweite Montageseite 04 schräg zur durch die Lichtabstrahlrichtung 07 der Leuchtdiode 01 definierten Achse 08 orientiert ist.

Bei der in den Fig. 1 bis Fig. 3 dargestellten Leuchtdiode 01 handelt es sich um Montagewinkel von 30° und 90°. Letzterer Montagewinkel entspricht einer normal zur durch die Lichtabstrahlrichtung 07 der Leuchtdiode 01 definierten Achse 08 orientierten Montageseite 03. Die verschiedenen Montagewinkel ergeben sich durch die unterschiedlichen Orientierungen der verschiedenen Montageseiten 03, 04 gegenüber der durch die Lichtabstrahlrichtung 07 der Leuchtdiode 01 definierten Achse 08.

Selbstverständlich können die verschiedene Montageseiten 03, 04 Bezug nehmend auf eine durch die Lichtabstrahlrichtung 07 der Leuchtdiode 01 gebildete Achse 08 auch andere unterschiedliche Winkel, beispielsweise Winkel von 0°, 15°, 30°, 45°, 60°, 75°, 90° einschließen.

Die Leuchtdiode 01 kann einen unter Freilassung an den Montageseiten 03, 04 die elektrischen Anschlüsse 05, 06 zumindest teilweise umgebenden, vorzugsweise durch Spritzgießen aus Kunststoff hergestellten Schutzkörper 09 umfassen.

Die Montageseiten 03, 04 können durch die Form des Schutzkörpers 09 definiert und hergestellt sein. Der Schutzkörper 09 kann beispielsweise ein Gehäuse der Leuchtdiode 01 bilden. Die Leuchtdiode 01 weist dadurch aufgrund ihrer Gehäuseform mehrere Montageseiten 03, 04 mit gemeinsamen oder jeweils eigenen elektrischen Anschlüssen 05, 06 auf.

Jede der Montageseiten 03, 04 kann mit eigenen elektrischen Anschlüssen 05, 06 versehen sein.

Zumindest die Orientierung wenigstens einer Montageseite 03, 04 kann durch die der Lichtabstrahlrichtung 07 der Leuchtdiode 01 abgewandte Rückseite des LED-Chips 02 definiert und/oder hergestellt sein.

Alternativ oder zusätzlich ist denkbar, dass wie in Fig. 1 und Fig. 2 dargestellt zumindest die Orientierung wenigstens der Montageseite 03 durch eine an die der Lichtabstrahlrichtung 07 der Leuchtdiode 01 abgewandte Rückseite des LED-Chips 02 angrenzende Fläche des LED-Chips 02 definiert und/oder hergestellt ist.

Die verschiedenen Montageseiten 03, 04 können bezüglich einer durch die Lichtabstrahlrichtung 07 der Leuchtdiode 01 definierte Achse 08 auf der selben Seite angeordnet sein.

Alternativ oder zusätzlich können verschiedene Montageseiten 03, 04 bezüglich einer durch die Lichtabstrahlrichtung 07 der Leuchtdiode 01 definierte Achse 09 in verschiedenen Winkeln bevorzugt gleichmäßig um die Achse 08 herum verteilt angeordnet sein.

Die Leuchtdiode 01 kann wie in den Fig. 1 bis Fig. 3 dargestellt als SMD-LED ausgeführt sein. Hierbei sind die elektrischen Anschlüsse 05, 06 zur Oberflächenmontage ausgebildet, im Gegensatz zu den bei einer als THT-Leuchtdiode ausgebildeten Leuchtdiode 01 als Beinchen ausgebildeten elektrischen Anschlüssen 05, 06.

Die Leuchtdiode 01 kann belinst sein. Hierzu kann zumindest die beispielsweise einen Primärreflektor für den LED-Chip 02 bildende Aussparung 10 zumindest zum Teil mit einer transparenten Vergussmasse verfüllt sein.

Alternativ oder zusätzlich kann die Leuchtdiode 01 mit mindestens einem Lichtleiter gekoppelt sein. Hierzu kann mindestens ein Lichtleiter mit wenigstens einer zur Lichteinkopplung in den Lichtleiter vorgesehenen Lichteinkoppelfläche sowie zumindest einer von der wenigstens einen Lichteinkoppelfläche verschiedenen Lichtauskoppelfläche, durch die das in den Lichtleiter an der Lichteinkoppelfläche eingekoppelte Licht wieder aus dem Lichtleiter austritt, mit seiner Lichteinkoppelfläche an die Leuchtdiode 01 angespritzt sein.

Die Erfindung ist insbesondere im Bereich der Herstellung von Leuchtdioden bzw. LEDs als Lichtquellen für Beleuchtungszwecke gewerblich anwendbar.

### Bezugszeichenliste

- 01: Leuchtdiode
- 02: LED-Chip
- 03: Montageseite
- 04: Montageseite
- 05: elektrischer Anschluss
- 06: elektrischer Anschluss
- 07: Lichtabstrahlrichtung
- 08: durch die Lichtabstrahlrichtung definierte Achse
- 09: Schutzkörper

## Patentansprüche

1. Leuchtdiode (01) mit mindestens einem LED-Chip (02) und einer Montageseite (03, 04) mit elektrischen Anschlüssen (05, 06) zur elektrischen Kontaktierung des LED-Chips (02),
**gekennzeichnet durch**
mindestens zwei verschiedene, in unterschiedlichen Richtungen zu einer **durch** die Lichtabstrahlrichtung (07) der Leuchtdiode (01) definierten Achse (08) orientierten Montageseiten (03, 04).

2. Leuchtmittel mit wenigstens einem Leuchtmittelträger und wenigstens zwei auf dem mindestens einen Leuchtmittelträger vorgesehenen Montageflächen und wenigstens zwei mit ihren Lichtabstrahlrichtungen (07) eine Leuchtdichteverteilung in wenigstens zwei Vorzugsrichtungen erfüllenden Leuchtdioden (01) als Lichtquellen, von denen jede Leuchtdiode (01) mit einer Montageseite (03, 04) auf einer der Montageflächen unter mechanischer Befestigung und elektrischer Kontaktierung mit Leiterbahnen des Leuchtmittelträgers angeordnet ist,
**gekennzeichnet durch**
mindestens zwei zur Erfüllung unterschiedlicher Vorzugsrichtungen mit ihren Lichtabstrahlrichtungen (07) mit unterschiedlichen Montageseiten (03, 04) auf verschiedenen Montageflächen des Leuchtmittelträgers angeordneten Leuchtdioden (01) nach Anspruch 1.

3. Leuchtdiode oder Leuchtmittel nach Anspruch 1 oder 2,
**dadurch gekennzeichnet,**
**dass** jede Montageseite (03, 04) mit eigenen elektrischen Anschlüssen (05, 06) versehen ist.

4. Leuchtdiode oder Leuchtmittel nach Anspruch 1, 2 oder 3,
**gekennzeichnet durch**
einen unter Freilassung an den Montageseiten (03, 04) die elektrischen Anschlüsse (05, 06) zumindest teilweise umgebenden, vorzugsweise **durch** Spritzgießen aus Kunststoff hergestellten Schutzkörper (09).

5. Leuchtdiode oder Leuchtmittel nach Anspruch 4,
**dadurch gekennzeichnet,**
**dass** die Montageseiten (03, 04) durch die Form des Schutzkörpers (09) definiert und hergestellt sind.

6. Leuchtdiode oder Leuchtmittel nach einem der vorhergehenden Ansprüche, **dadurch gekennzeichnet,**
**dass** zumindest die Orientierung wenigstens einer Montageseite (03, 04) durch die der Lichtabstrahlrichtung (07) der Leuchtdiode (01) abgewandte Rückseite des LED-Chips (02) definiert und/oder hergestellt ist.

7. Leuchtdiode oder Leuchtmittel nach einem der vorhergehenden Ansprüche, **dadurch gekennzeichnet,**
**dass** zumindest die Orientierung wenigstens einer Montageseite (03, 04) durch eine an die der Lichtabstrahlrichtung (07) der Leuchtdiode (01) abgewandte Rückseite des LED-Chips (029 angrenzende Fläche des LED-Chips (02) definiert und/oder hergestellt ist.

8. Leuchtdiode oder Leuchtmittel nach einem der vorhergehenden Ansprüche, **dadurch gekennzeichnet,**
**dass** verschiedene Montageseiten (03) bezüglich einer durch die Lichtabstrahlrichtung (07) der Leuchtdiode (01) definierte Achse (08) auf der selben Seite angeordnet sind.

9. Leuchtdiode oder Leuchtmittel nach einem der vorhergehenden Ansprüche, **dadurch gekennzeichnet,**
**dass** verschiedene Montageseiten (03, 04) bezüglich einer durch die Lichtabstrahlrichtung (07) der Leuchtdiode (01) definierte Achse (08) bevorzugt gleichmäßig um die Achse (08) herum verteilt angeordnet sind.

10. Leuchtdiode oder Leuchtmittel nach einem der vorhergehenden Ansprüche, **dadurch gekennzeichnet,**
**dass** Bezug nehmend auf eine durch die Lichtabstrahlrichtung (07) der Leuchtdiode (01) gebildete Achse (08) verschiedene Montageseiten (03, 04) Winkel von 0°, 15°, 30°, 45° 60°, 75° 90°einschließen.

11. Leuchtdiode oder Leuchtmittel nach einem der vorhergehenden Ansprüche, **dadurch gekennzeichnet,**
**dass** die Leuchtdiode (01) belinst ist.

12. Leuchtdiode oder Leuchtmittel nach einem der vorhergehenden Ansprüche, **dadurch gekennzeichnet,**
**dass** an die Leuchtdiode (01) mindestens ein Lichtleiter mit wenigstens einer zur Lichteinkopplung in den Lichtleiter vorgesehenen Lichteinkoppelfläche sowie zumindest einer von der wenigstens einen Lichteinkoppelfläche verschiedenen Lichtauskoppelfläche, durch die das in den Lichtleiter an der Lichteinkoppelfläche eingekoppelte Licht wieder aus dem Lichtleiter austritt, angespritzt ist.

13. Leuchtdiode oder Leuchtmittel nach einem der vorhergehenden Ansprüche, **dadurch gekennzeichnet,**
**dass** die Leuchtdiode (01) als SMD-LED ausgeführt ist.

14. Leuchtdiode oder Leuchtmittel nach einem der vorhergehenden Ansprüche, **dadurch gekennzeichnet,**
**dass** die Leuchtdiode (01) als THT-LED ausgeführt ist.

15. Leuchtdiode oder Leuchtmittel nach einem der vorhergehenden Ansprüche, **gekennzeichnet durch**
zwei Montageseiten (03, 04), eine normal zur **durch** die Lichtabstrahlrichtung (07) der Leuchtdiode (01) definierten Achse (08) orientierte erste Montageseite (03) und eine zweite, parallel oder schräg zur **durch** die Lichtabstrahlrichtung (07) der Leuchtdiode (01) definierten Achse (08) orientierte Montageseite (04).
